# EUROPEAN PATENT APPLICATION

(11) **EP 0 628 994 A2**
(43) Date of publication of application: **14.12.1994**
(21) Application number: 94108961.7
(22) Date of filing: 10.06.1994
(51) Int. Cl.: H01L 21/316, H01L 21/306

(54) **Heat treatment method for semiconductor substrate**

(30) Priority: 10.06.1993 JP 138536/93
(71) Applicant: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi, Kanagawa-ken (JP)
(72) Inventor: Samata, Shuichi, Yokohama-shi, Kanagawa-ken (JP); Fukui, Hiroyuki, Ooita-shi, Ooita-ken (JP); Inoue, Yoko, Yokohama-shi, Kanagawa-ken (JP)
(74) Representative: Hansen, Bernd, Dr. Dipl.-Chem.

(57) **Abstract**

In the heat treatment method of a semiconductor substrate, a semiconductor substrate is placed in a furnace and heat treated in a reducing or inert atmosphere at temperature higher than 1100°C for a predetermined time; the reducing or inert atmosphere is replaced with nitrogen gas, after the atmosphere has been lowered to or when being lowered to a predetermined temperature; and thereafter the heat treated semiconductor substrate is taken out from the furnace. In particular, the predetermined temperature lies between 600°C and 850°C. In the above heat treatment method, although the substrate is heat treated in the reducing or inert atmosphere at 1100°C or higher, since the atmosphere is replaced with the nitrogen gas at enough low temperature that a nitride film which increases the surface roughness of the substrate is not formed on the substrate surface, thus eliminating gate oxide deterioration caused by the nitridation itself.

## Description

### BACKGROUND OF THE INVENTION

### Field of the Invention

The present invention relates to a heat treatment method for a semiconductor substrate, and more specifically to a method of heat treating a semiconductor substrate in such a way that after the semiconductor substrate placed in a furnace has been heat treated within a reducing or inert atmosphere for a predetermined time, the heat treated semiconductor substrate is taken out of the furnace.

### Description of the Prior Art

With the advance of microminiaturization and higher integration of MOS type ULSI, the dimension of MOS transistors have been decreased in accordance with scaling rule, and further the gate oxide thickness of MOS transistor has been reduced more and more.

On the other hand, the supply voltage is not decreased in accordance to the scaling rule. As a result, the electric field applied to the gate oxide of MOS transistor has been increased more and more in the operation of MOS device.

In the gate oxide film, there are some defects, which cause to break down by the electric field between 2 and 8 MV/cm, introduced during crystal growth. These defects in gate oxide causes some part of reliability failure of MOS devices.

Accordingly, it is necessary to perfectly eliminate the defects of gate oxide , in particular in the case of micro-devices on the order of less than half micrometers.

As an effective method of eliminating the defect of the oxide film caused by the substrate, such a heat treatment method has been noticed that the semiconductor substrate placed in a furnace is heat treated within a reducing (e.g., H₂, CO, etc.) or inert (e.g., He, Ar, Ne, Xe, Kr, etc.) atmosphere at the temperature of higher than 1100°C.

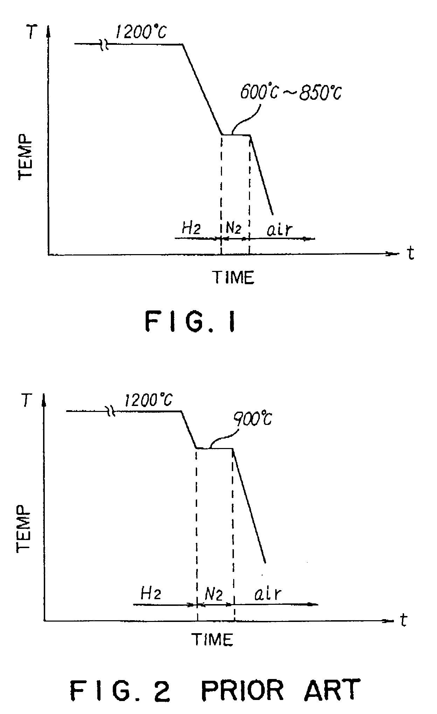

In this method, however, when the reducing atmosphere such as H₂ is used, since there exists a danger of explosion, the atmosphere in furnace is replaced with nitrogen gas after the temperature has been lowered to about 900°C, and the semiconductor substrate is taken out of the furnace, as shown in Fig. 2. By this conventional heat treatment method, it is possible to eliminate the defect of the oxide film caused by the substrate.

In the conventional heat treatment method, however, there exists another problem of the oxide film due to the reasons as follows:
Within the reducing or inert atmosphere heated up to the temperature higher than 1100 °C, since the natural oxide film formed on the surface of the semiconductor substrate is perfectly removed, the substrate surface becomes very active. Therefore, when the reducing or inert atmosphere is replaced with nitrogen gas after the substrate temperature has been lowered down to about 900°C, a nitride film is inevitably formed on the substrate surface, so that the surface roughness of the substrate increases due to the subsequent washing treatment. As a result, there arises a problem in that the gate oxide film deteriorates and thereby the breakdown voltage drops, thus there existing a need of overcoming this problem.

### SUMMARY OF THE INVENTION

With these problems in mind, therefore, it is the object of the present invention to provide a heat treatment method for a semiconductor substrate, by which when the semiconductor substrate is heat treated in a reducing or inert atmosphere at a temperature higher than 1100°C and further when the atmosphere is replaced with a nitrogen gas, no nitride film is formed on the substrate surface so that the surface roughness of the substrate will not be increased, thus eliminating the deterioration of the oxide film caused by the surface nitridation.

To achieve the above-mentioned object, the first aspect of the present invention provides a heat treatment method for a semiconductor substrate, comprising the steps of: heat treating the semiconductor substrate placed in a furnace within a reducing or inert atmosphere at temperature higher than 1100°C for a predetermined time; replacing the atmosphere with a nitrogen gas, after the temperature in the furnace has been lowered down to between 600°C and 850°C; and taking out the heat treated semiconductor substrate form the furnace.

The above-mentioned temperature range between 600°C and 850°C is determined as follows: The nitridation reaction is prominent at the temperature higher than about 850°C. Therefore, it is preferable that the reducing or inert atmosphere is replaced with the nitrogen gas after the temperature of the atmosphere has been once reduced down to 850°C or lower. Further, it is also preferable to replace the reducing or inert atmosphere with the nitrogen gas at a the temperature higher than 600°C. This is because when the Si substrate grown by the CZ method is heat treated at the
temperature between 400 and 600°C for a long time over a predetermined heat treatment time, the nucleation of oxygen in the Si substrate may take place excessively, thus resulting in a problem such as mechanical strength decrease.

In the first aspect of the heat treatment method according to the present invention, since the atmosphere is replaced with the nitrogen gas after the atmosphere temperature has been lowered down to the temperature between about 600°C and 850°C, even if the atmosphere is replaced with the nitrogen gas, nitride film is not formed on the substrate surface, so that it is possible to prevent the substrate surface from being roughened.

Further, the second aspect of the present invention provides a heat treatment method for a semiconductor substrate, comprising the steps of: heat treating the semiconductor substrate placed in a furnace within a reducing atmosphere at temperature higher than 1100°C for a predetermined time; replacing the atmosphere with an inert atmosphere; and further heat treating the heat treated semiconductor substrate in the furnace or taking out the heat treated semiconductor substrate form the furnace.

In the second aspect of the heat treatment method according to the present invention, after the substrate has been heat treated in the reducing atmosphere at 1100°C or higher for a predetermined time, since the reducing atmosphere is replaced with the inert gas without using nitrogen gas, it is possible to prevent nitride film formation on the substrate surface.

### BRIEF DESCRIPTION OF THE DRAWINGS

Fig. 1 is a graphical representation for assistance in explaining the heat treatment process of a first embodiment of the heat treatment method for the semiconductor substrate according to the present invention;
Fig. 2 is a graphical representation for explaining the heat treatment process of the conventional heat treatment method for the semiconductor substrate;
Fig. 3 is a graphical representation showing the dependence of nitridation reaction upon temperature, that is, the relationship between nitride quantity and temperature;
Fig. 4 is a diagrammatical cross-sectional view showing a heat treating furnace;
Figs. 5(a) to (d) are illustrations showing the surface roughness of the wafer heat treated in accordance with a second embodiment according to the present invention in comparison with the conventional method, in which Fig. 5(a) shows the wafer surface by the second embodiment method before washed by RCA Method; Fig. 5(b) shows the same wafer surface after washed by the RCA Method; Fig. 5(c) shows the wafer surface by the conventional embodiment before washed by the RCA Method; and Fig. 5(d) shows the same wafer surface after washed by the RCA, respectively; and
Fig. 6(a) is a graphical representation showing the relationship between leak current of gate oxide and electric field applied to the oxide film o the wafer heat-treated in accordance with the second embodiment according to the present invention; and Fig. 6(b) is a similar graphical representation of the gate oxide film of the wafer heat-treated in accordance with the conventional method.

### DETAILED DESCRIPTION OF THE PREFERRED EMBODIMENTS

A first embodiment of heat treatment method for a semiconductor substrate according to the present invention will be described hereinbelow in comparison thereof with the conventional method and the comparative method.

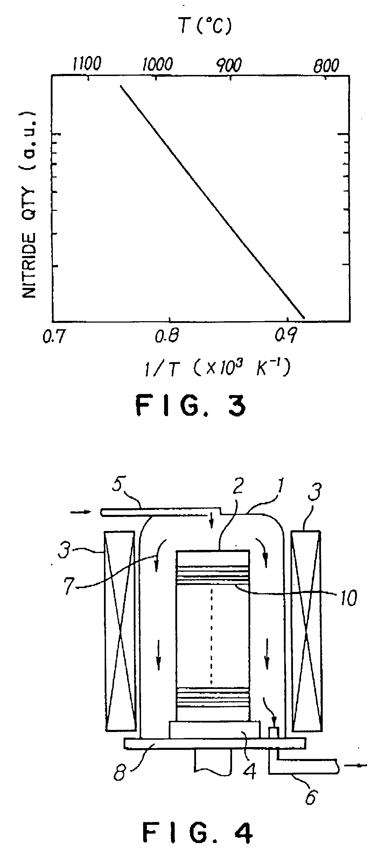

Prior to the description of the heat treating methods, a furnace of heat treating the semiconductor wafer will be first described hereinbelow with reference to Fig. 4.

In Fig. 4, a heat treating furnace is provided with a furnace chamber 1 formed of a quartz tube, heater 3 arranged on the outer circumferential side of the furnace chamber 1, and a boat 2 disposed inside the furnace chamber 1. Further, a gas charging tube 5 is connected to the upper portion of the furnace chamber 1 and a gas discharge tube 6 is connected to the bottom portion of the furnace. A gas 7 introduced through the gas charge tube 5 is discharged through the gas discharge tube 6. The boat 2 is mounted on a boat base 4. A plurality of silicon substrates 10 to be heat treated are inserted horizontally onto the boat 2 to place the substrates 10 in the furnace chamber 1.

On the other hand, Fig. 3 shows the dependence of the reaction between nitrogen gas and Si substrate surface upon the temperature, that is, the relationship between the nitridation quantity on the wafer surface and the substrate temperature. Fig. 3 indicates that the nitridation reaction is prominent at temperature higher than 850°C. Therefore, it is preferable that the reducing or inert atmosphere is replaced with the nitrogen gas after the atmosphere temperature has been reduced to temperature about 850°C or lower. Further, it is also preferable to replace the reducing or inert atmosphere with the nitrogen gas at a temperature higher than 600°C. This is because when the Si substrate grown by the CZ method is heat treated at a temperature between 400°C and 600°C for a long time, the nucleation oxygen in the Si substrate takes place excessively, thus resulting in a problem such as the mechanical strength decrease.

### 〈Embodiment method 1〉

With reference to Fig. 1, the first embodiment method 1 will be described hereinbelow.

The wafers 10 of phosphorous doped N-type of (100) surface orientation grown by CZ method and having a resistivity of 10 Ω.cm were mounted on the boat 2 within the heat treating furnace chamber 1. As the gas 7, reducing gas of H₂ was used. The temperature of the atmosphere in the furnace chamber 1 was kept at 1200°C for one hour during heat treatment. After that, the temperature in the furnace chamber 1 was lowered down to 800°C, laying between 600°C and 850°C, by controlling the heater 3. At this lowered temperature, the H₂ gas within the heat treating furnace chamber 1 was replaced with nitrogen gas sufficiently. Thereafter, the wafers 10 were taken out of the heat treating furnace chamber 1.

### 〈Conventional method〉

With reference to Fig. 2, the conventional method will be described hereinbelow.

The H₂ gas within the heat treating furnace chamber 1 was replaced with the nitrogen gas at about 900°C (which is higher than the temperature range between 600°C and 850°C). After that, the wafers 10 were taken out of the heat treating furnace 1. The other heat treatment conditions were quite the same as the case of the embodiment method 1.

### 〈Comparative example〉

The H₂ gas within the heat treating furnace chamber 1 was replaced with the nitrogen gas at 500°C (which is lower than the temperature range between 600°C and 850°C). After that, the wafers 10 were taken out of the heat treating furnace chamber 1. The other heat treatment conditions were quite the same as the case of the embodiment method 1.

After all the wafers 10 were taken out of the heat treating furnace chamber 1 in the embodiment method 1, the conventional method and the comparative method, the concentrations of the nitride film formed on the surfaces of these wafers 10 were measured by XPS method (X-ray Photo-electron Spectroscopy). The measurement results indicated that the presence of the nitride film was confirmed in the conventional method, however, no formation of the nitride film was confirmed in the embodiment method 1 and the comparative example.

Further, 16-M DRAMs were manufactured by use of the wafers 10 heat treated in accordance with the embodiment method 1, the conventional method, and the comparative method. The production yield was the best in the embodiment method 1, intermediate in the conventional method, and the worst in the comparative method. In the embodiment method 1, in particular, the production yield was improved as large as 5 to 10% in comparison with the conventional method.

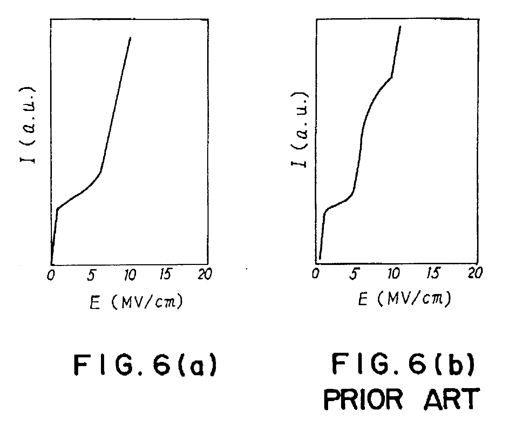

In the case of the conventional method, since the surface roughness of the wafers 10 increased due to the nitridation reaction on the wafer surface in the H₂ heat treatment process in comparison with the embodiment method 1, the breakdown voltage of the oxide film was lowered as shown in Fig.6, with the result that the production yield was reduced in comparison with the embodiment method 1.

In the comparative method, on the other hand, although the wafer surfaces were not nitrized and therefore the surface roughness was excellent as with the case of the embodiment method 1, many oxygen precipitate was about 10 times more than with the case of the embodiment method 1 was introduced. As a result, the mechanical strength of the substrate was lowered, so that the slip defects (dislocations) were produced on the middle portion of the wafers 10 due to thermal stress generated in the device manufacturing process. Consequently, the production yield of the wafers of the comparative method was lowered extremely in comparison with the embodiment method 1 and the conventional method.

In addition, EEPROMs (which require more sever characteristics with respect to the breakdown voltage and leak current of the oxide film) were manufactured with the use of wafers 10 heat treated in accordance with the embodiment method 1 and the conventional method, for comparison of the performance between the two. The production yield of the embodiment method 1 was improved by about 10%, as compared with that of the conventional method. And it was observed to reduce the failure of reliability test by the embodiment method 1.

As described above, in the first embodiment of the heat treatment method (the embodiment method 1) according to the present invention, although the wafers are heat treated in the reducing atmosphere at a temperature higher than 1100°C, since the atmosphere is replaced with the nitrogen gas at enough low temperature of 800°C, no nitride film is formed on the substrate surface, so that the surface roughness of the substrate dose not increase, with the result that it is possible to eliminate the gate oxide deterioration deterioration caused by the surface nitridation.

Further, it is possible to use CO gas as the reducing atmosphere instead of H₂. Further, the same effect can be obtained when an inert gas such as He, Ar, Ne, Xe, Kr, etc. is used instead of the reducing atmosphere.

Further, in the embodiment method 1, an improvement of the production yield of about 5 to 10% has been confirmed, in comparison with the conventional method. However, where the wafers 10 heat treated in accordance with the embodiment method 1 are used for the highly integrated devices such as 64-M DRAMs or other devices higher in the integration level, it is possible to expect a further improvement in the production yield.

The second embodiment of the heat treatment method according to the present invention will be described hereinbelow.

The wafers 10 of phosphorous doped N-type of (100) surface direction grown by the CZ method and having a resistivity of 10 Ω.cm were used and heat treated in accordance with first and second modifications of the second embodiment method according to the present invention, in comparison with the conventional method. As the reducing atmosphere, a H₂ gas was used.

### 〈First modification of the second embodiment〉

After the wafers 10 were annealed in hydrogen atmosphere at 1200°C for one hour, the hydrogen gas was replaced with an Ar gas without lowering the temperature in the heat treating furnace chamber 1. After the atmosphere was replaced with the Ar gas sufficiently, the temperature was lowered. After that, the wafers were taken out of the heat treating furnace 1, which is referred to as the wafers of the first modification 1 of the second embodiment 2, that is, the embodiment method 2-1.

### 〈Second modification of the second embodiment〉

After the wafers 10 were annealed in hydrogen atmosphere at 1200°C for one hour, the hydrogen gas was replaced with an Ar gas when the temperature in the heat treating furnace chamber 1 was being lowered. After the atmosphere was replaced with the Ar gas sufficiently and the temperature was lowered, the wafers were taken out of the heat treating furnace 1, which is referred to as the wafers of the second modification 2 of the second embodiment 2, that is, the embodiment method 2-2.

### 〈Conventional method〉

In the same way as with the case of the embodiment method 2-1, after the wafers 10 were annealed in hydrogen atmosphere at 1200°C for about one hour, the hydrogen gas was replaced with a nitrogen gas without lowering the temperature in the heat treating furnace chamber 1. After the atmosphere was replaced with the nitrogen gas sufficiently, the temperature was lowered. After that, the wafers were taken out of the heat treating furnace chamber 1, which is referred to as the wafers of the conventional method of the second method.

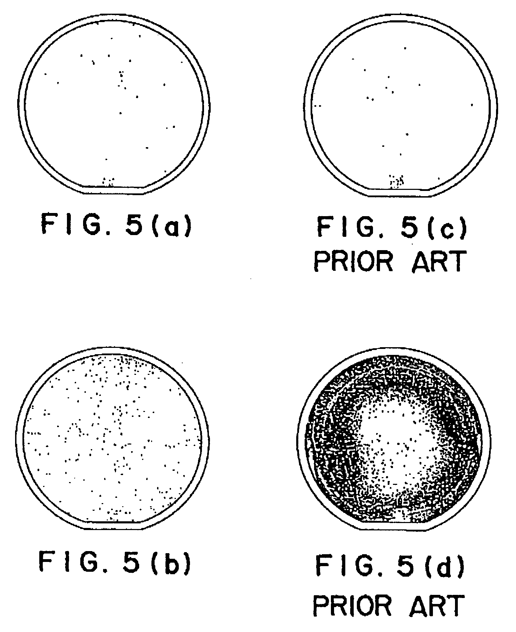

The respective wafers heat treated in accordance with the embodiment methods 2-1 and 2-2 and the conventional method were washed by RCA Method, and thereafter the wafer surfaces were observed. Figs. 5(a) to (d) show the observed wafer surfaces. In more detail, Figs. 5(a) and (b) show the wafer surfaces obtained before (Fig. 5(a)) and after (Fig. 5(b)) washed by RCA Method in the embodiment methods 2-1 and 2-2. Further, Fig. 5(c) and (d) show the wafer surfaces obtained before (Fig. 5(c)) and after (Fig. 5(d)) washed by RCA method
in the conventional method. Fig. 5(c) and (d) indicate that in the case of the conventional method, the excessive increase of surface roughness was found on the surface of the wafer. On the rough surface portion, nitrogen of more than 10 atomic % was detected by the XPS Method(X-ray Photo-electron Spectroscopy). In contrast with this, rough surface nor nitridation were both not detected in the wafers heat treated in accordance with the embodiment methods 2-1 and 2-2.

Further, MOS capacitors were manufactured by use of these wafers by the embodiment methods 2-1 and 2-2 and the conventional method, and then the breakdown voltages of the oxide films were evaluated. Fig. 6(a) shows the relationship between leakage current and the electric field strength of the oxide films of the wafers heat treated in accordance with the embodiment methods 2-1 and 2-2, and Fig. 6(b) shows the leakage current of the oxide film of the wafer heat treated in accordance with the conventional method. Figs. 6(a) and (b) indicate that the leakage current flowing through the oxide films formed on the wafers heat treated by the embodiment methods 2-1 and 2-2 is lower than that of the wafer heat treated by the conventional method. And it is clear that the break down voltage in the conventional method is much lower than that of the embodiment methods 2-1 and 2-2.

Further, 4M-EEPROMs were manufactured by use of the wafers heat treated in accordance with these three methods. When the wafers heat treated by the conventional method were used, many device failures due to the increase of the leakage current through the oxide films were found. On the other hand, when the wafers heat treated by the embodiment methods 2-1 and 2-2 were used, no leakage current failure was observed. As described above, even in the 4-M EEPROM (even a minute oxide leakage current is not acceptable), an effectiveness of the embodiment methods 2-1 and 2-2 was confirmed, in comparison with the conventional method.

Further, in the first and second modifications of the second embodiment, although hydrogen gas was replaced with Ar gas, in the embodiment methods 2-1 and 2-2, it is possible to use an inert gas such as Ne, He, Xe or Kr as the replacement gas, instead of the Ar gas.

As described above, in the second embodiment of the heat treatment method according to the present invention, after the wafers have been heat treated in the hydrogen atmosphere at a high temperature, since the hydrogen gas is replaced with inert gas (without use of the nitrogen gas), it is possible to prevent nitride film (formed when the nitrogen gas is used) from being formed on the wafer surface.

As described above, in the first embodiment of the heat treatment method according to the present invention, since the atmosphere is replaced with nitrogen gas after the heat treatment in reducing or inert atmosphere above 1100°C and cooling down to about 850°C or lower, it is possible to prevent a nitride film from being formed on the substrate surface so that the increase of roughness on the wafer surface can be suppressed, with the result that it is possible to provide a heat treatment method for the semiconductor substrate which can prevent the increase of gate oxide failure caused by the surface nitridation.

Further, in the second embodiment of the heat treatment method according to the present invention, after the substrate has been heat treated in reducing atmosphere at temperature higher than 1100°C, since the reducing atmosphere is replaced with inert gas without use of nitrogen gas, it is possible to prevent a nitride film from being formed on the substrate surface.

## Claims

1. A heat treatment method of a semiconductor substrate, comprising the steps of:
heat treating the semiconductor substrate placed in a furnace in a reducing or inert atmosphere at temperature higher than 1100°C for a predetermined time;
replacing the atmosphere with a nitrogen gas, after the atmosphere temperature has been lowered or when being lowered down to a temperature between about 600°C and about 850°C; and taking out the heat treated semiconductor substrate from the furnace.

2. The heat treatment method of claim 1, wherein the reducing atmosphere is H₂ gas.

3. The heat treatment method of claims 1 or 2, wherein the predetermined time is more than 10 minutes.

4. A heat treatment method for a semiconductor substrate, comprising the steps of:
heat treating the semiconductor substrate placed in a furnace within a reducing atmosphere at temperature higher than 1100°C for a predetermined time;
replacing the atmosphere with an inert atmosphere; and
further heat treating the heat treated semiconductor substrate in the furnace or taking out the heat treated semiconductor substrate form the furnace.

5. The heat treatment method of claim 4, wherein the reducing atmosphere is H₂ gas.

6. The heat treatment method of claim 4, wherein the inert atmosphere is Ar gas atmosphere.

7. The heat treatment method of claims 4,5 or 6 wherein the reducing atmosphere is replaced with the inert atmosphere without lowering the furnace temperature.

8. The heat treatment method of claims 4,5 or 6 wherein the reducing atmosphere is replaced with the inert atmosphere when the furnace temperature is being lowered.

9. A heat treated semiconductor substrate of low surface roughness producible by the method outlined in any of claims 1 to 8.

10. The use of a heat treated semiconductor substrate as defined in claim 9 in electrical or electronic devices.
